Europäisches Patentamt

European Patent Office

Office européen des brevets

(19)

(11) **EP 0 464 251 B1**

(12) # EUROPEAN PATENT SPECIFICATION

(45) Date of publication and mention
of the grant of the patent:
**13.03.1996 Bulletin 1996/11**

(51) Int Cl.⁶: **H01L 27/108**

(21) Application number: **90112927.0**

(22) Date of filing: **06.07.1990**

(54) **Dynamic random access memory having improved layout and method of arranging memory cell pattern**

Dynamischer Speicher mit wahlfreiem Zugriff mit verbessertem Layout und Methode zur Anordnung des Speicherzellenmusters

Mémoire dynamique à accès aléatoire ayant un agencement amélioré et procédé d'arranger la configuration des cellules de mémoire

(84) Designated Contracting States:
**DE FR GB**

(43) Date of publication of application:
**08.01.1992 Bulletin 1992/02**

(60) Divisional application: **95112708.3**

(73) Proprietor: **FUJITSU LIMITED**
**Kawasaki-shi, Kanagawa 211 (JP)**

(72) Inventor: **Ema, Taiji**
**Kawasaki-shi, Kanagawa 213 (JP)**

(74) Representative: **Seeger, Wolfgang, Dipl.-Phys.**
**SEEGER & SEEGER**
**Patentanwälte & European Patent Attorneys**
**Georg-Hager-Strasse 40**
**D-81369 München (DE)**

(56) References cited:
**EP-A- 0 399 531**        **DE-A- 3 821 405**
**GB-A- 2 137 018**

- **PATENT ABSTRACTS OF JAPAN, vol.13, no.594 (E-867)(3942), 27 December 1989 & JP-A-1 248 556**
- **IEEE JOURNAL OF SOLID-STATE CIRCUIT, vol.24,no.5, October 1989, pages 1206-1212, New York, US; M.AOKI et al.: "A 1.5-V DRAM for battery-based applications"**
- **PATENT ABSTRACTS OF JAPAN, vol.13, no.459 (E-832), 17 October 1989& JP-A-1 179 449**
- **PATENT ABSTRACTS OF JAPAN, vol.11, no.376 (E-563)(2823), 8 December 1987 & JP-A-62 145 765**
- **PATENT ABSTRACTS OF JAPAN, vol.13, no.230 (E-764)(3578), 26 May 1989 &JP-A-1 036 063**
- **PATENT ABSTRACTS OF JAPAN, vol.13, no. 44 (E-710)(3392), 31 January 1989 & JP-A-63 239969**
- **PATENT ABSTRACTS OF JAPAN, vol.14, no. 273 (E-940)(4216), 13 June 1990& JP-A-2 086 164**
- **PATENT ABSTRACTS OF JAPAN, vol.13, no.594 (E-867)(3942), 27 December 1989 & JP-A-1 248556**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

BACKGROUND OF THE INVENTION

The present invention generally relates to a dynamic random access memory, and more particularly to a dynamic random access memory having an improved layout. Further, the present invention is concerned with a method of arranging a memory cell pattern of the dynamic random access memory.

Recently, the layout of structural elements of a dynamic random access memory (hereinafter simply referred to as a DRAM) has been designed by using a computer. In order to reduce the amount of data to be processed, the layout is designed by using straight lines extending in two orthogonal directions and straight lines extending at an angle of 45° with respect to each of the orthogonal directions. However, advanced computers have an ability to process an extremely large amount of data at high speeds and thus make it possible to design the layout by using oblique lines which extend at angles other than 45° with respect to the aforementioned orthogonal directions.

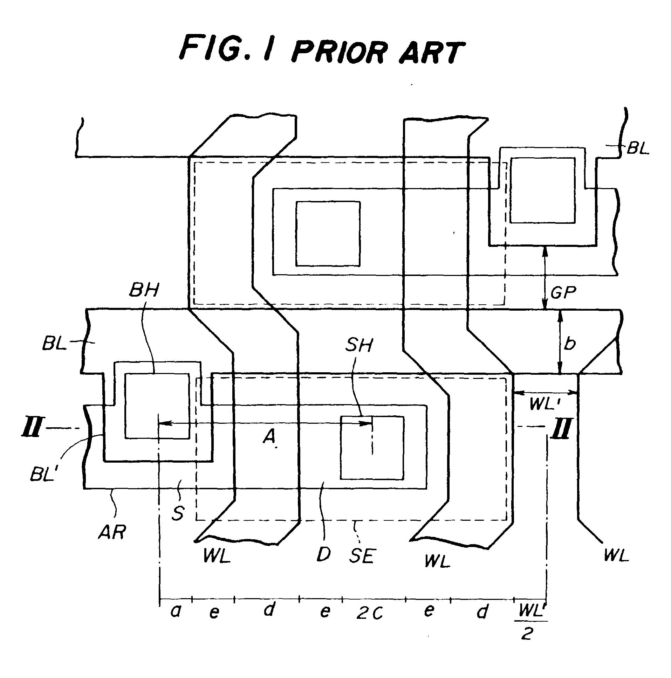

Referring to FIG.1, there is illustrated a layout of a DRAM of a stacked capacitor type. In FIG.1, AR indicates an active (diffusion) region including a drain region and a source region, a word line and S indicates a source area. D indicates a drain area. WL indicates a word line and WL' denotes the distance between the adjacent word lines WL. BL indicates a bit line and BL' indicates an extension portion of the bit line BL. BH indicates a bit line contact hole and SE indicates a storage electrode. SH indicates a storage electrode contact hole. GP is the space between the extension portion BL' of the bit line BL and the adjacent bit line BL.

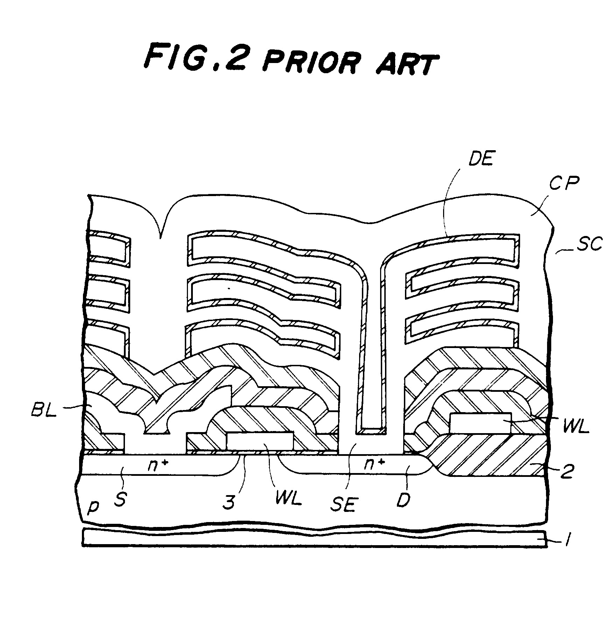

FIG.2 is a sectional view taken along line II-II shown in FIG.1. A P-type silicon semiconductor substrate 1 has a source region S and drain region D of a transfer transistor, both of which are active regions (impurity diffused regions) buried in the Si substrate 1. A field insulating layer 2 and a gate insulating layer 3 are formed on the Si substrate 1. CP indicates an opposed electrode (cell plate) of a storage capacitor. The bit line BL is formed at a layer level lower than that of the opposed electrode CP. The word line WL, the bit line BL, the storage electrode SE and the opposed electrode CP are stacked in this order. A stacked capacitor is composed of the storage electrode SE, a dielectric film DE and the cell plate CP. This arrangement would become popular as the size of memory cells is further reduced.

In the arrangement shown in FIGS.1 and 2, each bit line contact hole BH used for electrically coupling the bit line BL and the source region S of the transfer transistor must be positioned so that it keeps away from the word line WL. The storage electrode contact hole SH used for electrically coupling the storage electrode SE and the drain region D of the transfer transistor must be positioned so that it keeps away from both the word line WL and the bit line BL.

Each bit line BL must be provided with the extension portion BL' which is formed so that it surrounds the contact hole BH. The presence of the extension portion BL' increases the surface area of the bit line BL so that a parasitic capacitance is increased. In addition, the arrangement shown in FIGS.1 and 2 causes short circuiting in the vicinity of the bit line extension portion BL', since the distance GP between the bit line extension portion BL' and the adjacent bit line BL is smaller than the distance between the adjacent bit lines BL.

Length DM of each memory cell measured in the direction in which each bit line BL extends is described as follows.

$$DM = a + e + d + e + 2c + e + d + 1/2WL'$$
$$= A + c + e + d + 1/2WL'$$

where

a:      half the width of the bit line contact hole BH
e:      alignment margin of each of the contact holes
d:      the width of the word line WL
c:      half the width of the storage electrode contact hole SH
WL':    the distance between the adjacent word lines WL

It can be seen from FIG.1 that $A = a + e + d + e + c = a + c + d + 2e$. The bit line contact hole BL and the storage electrode contact hole SH are arranged approximately in a line so that the length DM of each memory cell is great.

Patent Abstracts of Japan, vol. 13, no. 594, 27.12.89 & JP-A-1 248 556 and Patent Abstracts of Japan, vol. 14, no. 273, 13.6.90 & JP-A-2 86164 each describe a memory device having a bent portion in the word line between a storage capacitor contact and a corresponding bit line contact.

Patent Abstracts of Japan, vol. 13, no. 459, 17.10.89 & JP-A-1 179 449 discloses that the active area has an inclination equal to 45° with respect to the bit line in order to most finely arrange the active areas and that the active areas with which the bit lines make contact are needed to extend in parallel with the bit lines.

EP-A-0 399 531, cited pursuant to Art. 54(3) EPC, shows a memory device having bent word line portions and obliquely arranged active regions.

## SUMMARY OF THE INVENTION

It is a general object of the present invention to provide a DRAM having an improved layout in which the aforementioned disadvantages are eliminated.

A more specific object of the present invention is to provide a DRAM having an improved layout which has no bit line extension portion for forming a bit line contact hole and which is directed to preventing the occurrence of short circuiting between the adjacent bit lines.

The above-mentioned objects of the present invention are achieved by a dynamic random access memory as defined in claim 1. Further embodiments of the invention are set out in the dependent claims.

Another object of the present invention is to provide a method of arranging a memory cell pattern of the above-mentioned dynamic random access memory.

This object of the present invention is achieved by a method according to attached claims 28 and 30.

## BRIEF DESCRIPTION OF THE DRAWINGS

Other objects, features and advantages of the present invention will become apparent from the following detailed description when read in conjunction with the accompanying drawings, in which:

FIG.1 is a diagram illustrating a conventional layout of a DRAM of a stacked capacitor type;
FIG.2 is a cross sectional view taken along line II-II shown in FIG.1;
FIG.3 is a diagram illustrating a principle of the present invention;
FIG.4 is a diagram illustrating a pattern according to a preferred embodiment of the present invention;
FIGS.5A and 5B are diagrams illustrating the influence of a bird's beak;
FIG.6 is a diagram of a pattern according to the embodiment of the present invention in which four memory cells are illustrated;
FIGS.7A, 7B and 7C are diagrams illustrating how the present invention was made; and
FIG.8 is a block diagram of a folded bit line type DRAM.

## DESCRIPTION OF THE PREFERRED EMBODIMENTS

The present invention is based on the following considerations.

First, in order to eliminate the aforemetioned extension portion BL' which projects from the bit line BL and which surrounds the bit line contact hole BH, it is the best way to arrange the bit line contact hole BL so that the center thereof is positioned on the center line of the bit line BL.

Second, it is advantageous to arrange the storage electrode contact hole SH so that the center thereof is positioned at an equal distance from the adjacent bit lines BL and at an equal distance from the adjacent word lines WL.

Third, an imaginary line which connects the bit line contact hole BH and the corresponding storage electrode contact hole SH crosses the bit line BL at an angle with respect to the direction in which the bit line BL extends, that is, the center line thereof. Active regions such as source and drain regions are arranged on the basis of the imaginary line. In addition, the shape of each word line WL is determined, taking into consideration the pattern of the active regions.

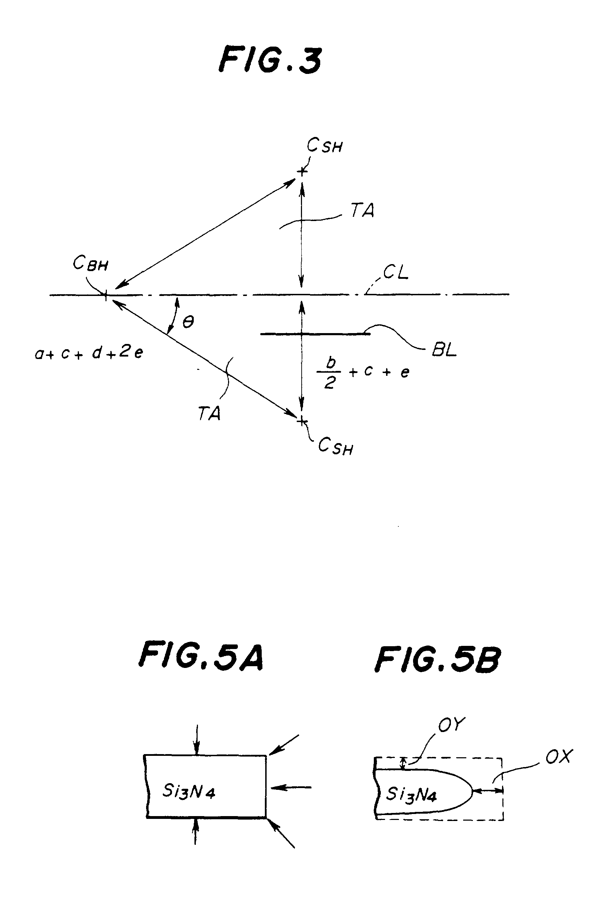

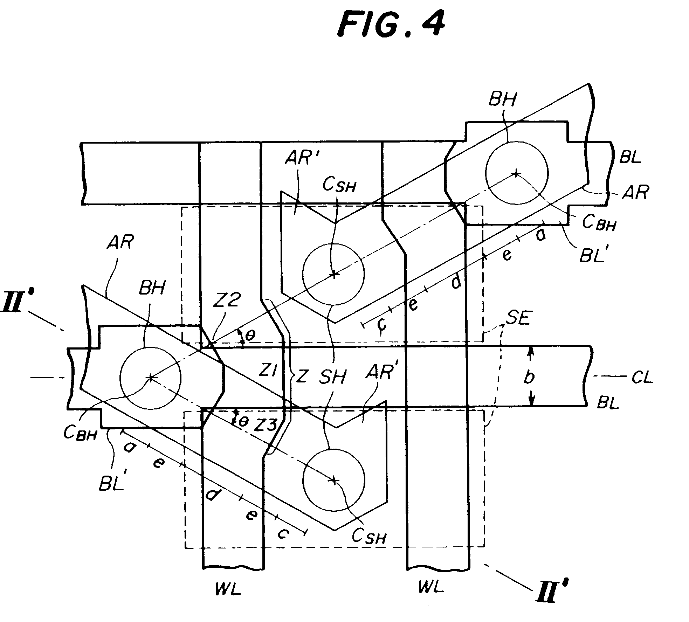

Referring to FIG.3, there is illustrated a principle of the present invention based on the above-mentioned first to third considerations. In FIG. 3, those parts which have the same names of structural elements as those shown in FIG.1 are given the same reference characters. CL indicates a center line of the bit line BL, and $C_{BH}$ indicates the center of the bit line contact hole BH. $C_{SH}$ indicates the center of the storage electrode contact hole SH, and $\theta$ indicates an angle formed between the center line CL and an imaginary line which connects the center $C_{BH}$ and $C_{SH}$.

A distance A between the center $C_{BH}$ of the bit line contact hole BH and the center $C_{SH}$ of the storage electrode contact hole SH, that is, the length A of the imaginary line therebetween is described as follows.

$$A = a + c + d + 2e$$

The distance between the center line CL of the bit line BL and the center $C_{SH}$ of the storage electrode contact hole BH is written as follows.

$$1/2b + c + e$$

It can be seen from FIG.3 that two right-angled isosceles triangles TA are formed. Thus, the able $\theta$ is written as follows.

$$\theta = \sin^{-1}[(1/2b + e + c)/(a + c + d + 2e)] \qquad (1)$$

The memory cell pattern is determined so that formula (1) is satisfied. It is possible to determine the memory cell pattern so that the angle $\theta$ is nearly equal to the right term of formula (1).

Referring to FIG.4, there is illustrated a layout of a DRAM according to a preferred embodiment of the present invention. In FIG.4, those parts which have the same names as those shown in the previous figures are given the same reference characters. In FIG.4, a letter b denotes the width of the bit line BL, and AR' indicates a bent portion of the active region AR. Z is a bent portion of the word line WL. Z1, Z2 and Z3 indicate areas of the word line WL which form the bent portion Z of the word line WL.

The center $C_{BH}$ of the bit line contact hole BH is positioned on the center line CL of the bit line BL. Although the bit line BL shown in FIG.4 has an extension portion for forming the bit line contact hole BH, it is very smaller than that shown in FIG.1. Thus, the distance between the extension portion of the bit line BL and the adjacent bit line BL is increased so that the occurrence of short circuiting therebetween can be reduced.

The length A of the imaginary line which connects the center $C_{BH}$ of the bit line contact hole BH and the center $C_{SH}$ of the storage electrode contact hole SH is equal to a + c + d +2e, as described previously. The angle θ of the line with respect to the center line CL of the bit line BL is selected, as defined by formula (1). The minimum distance between the center $C_{SH}$ of the storage electrode contact hole SH and the center line CL of the bit line BL is equal to 1/2b + c + e.

The active area AR extends along the imaginary line which connects the center $C_{BH}$ of the bit line contact hole BH and the center $C_{SH}$ of the storage electrode contact hole SH. That is, the active area AR is arranged obliquely with respect to the bit line BL. The active area AR has a bent portion AR' which is symmetrically bent or curved with respect to a line which passes through the center $C_{SH}$ of the storage electrode contact hole SH and which is perpendicular to the center line CL of the bit line BL.

The bent portion AR' of the active area AR reduces the influence of bird's beaks. Referring to FIG.5A, there is illustrated a silicon nitride ($Si_3N_4$) film used for selectively oxidizing the Si substrate to thereby produce an oxide layer (field insulating layer) for element-to-element isolation. Oxygen is supplied with a short end of the $Si_3N_4$ film along various directions, as shown by arrows in FIG.5A. Thus, the bird's beak occurs at the short end of the $Si_3N_4$ film and an Si substrate surface portion in the vicinity of the short end is oxidized, as indicated by arrow OX shown in FIG.5B. Although an Si substrate surface portion in the vicinity of a long end of the $Si_3N_4$ is also oxidized, as indicated by arrow OY shown in FIG.5B, it is smaller than that indicated by the arrow OX. The bent portion AR' of the active region AR is provided for taking into account the occurrence of the above-mentioned bird's beak. It should be noted that it is impossible to provide a bent portion which straight extends from the active area AR because of the presence of the bit line contact hole BH.

The direction in which each word line WL extends is perpendicular to the direction in which each bit line BL extends. Each word line WL has the bent portion Z, which is composed of the areas Z1, Z2 and Z3. The area Z1 is orthogonal to the center line CL of the bit line CL. The areas Z2 and Z3 are located on both sides of the area Z1. Each of the areas Z2 and Z3 is orthogonal to the corresponding line which connects the center $C_{BH}$ of the bit line contact hole BH and the center $C_{SH}$ of the storage electrode contact hole SH. The areas Z2 and 23 are arranged symmetically with the area Z1.

According to the layout shown in FIG.4, the length L of each memory cell measured in the direction in which the bit line BL extends is as follows.

$$L = 2 \text{ x } \sqrt{(a + c + d + 2e)^2 - (1/2b + c + e)^2}$$

It can be seen from the above formula that the length L of memory cell is not based on the distance WL' between the adjacent word lines. As a result, it is possible to increase the distance WL' and reduce the possibility of the occurrence of short circuiting.

When the minimum distance between the adjacent lines is 0.5 μm the parameters are selected as follows.

$$a = c = 0.3 \text{ μm}$$
$$b = d = 0.5 \text{ μm}$$
$$e = 0.4 \text{ μm}$$
$$WL' = 0.5 \text{ μm}$$

In this case, the length of each memory cell in the direction in which the bit line BL extends is 3.29 μm. On the other hand, the length of each memory in the same direction according to the aforementioned prior arrangement shown in FIG.1 is 3.35 μm when the distance between the adjacent word lines is set equal to 0.5 μm.

The distance between the adjacent word lines according to the arrangement shown in FIG.4 is 0.8 μm. On the other hand, the distance between the adjacent word lines according to the prior arrangement shown in FIG.1 is 0.5 μm.

The distance between the adjacent bit lines according to the arrangement shown in FIG.4 is 1.0 μm. On the other hand, the distance between the adjacent bit lines according to the prior arrangement shown in FIG.4 is 0.5 μm.

The area of each memory cell according to the arrangement shown in FIG.4 is slightly less than that shown in FIG.1. The distance between the adjacent bit lines BL and the word lines WL in the memory cells is 1.6 - 2 times that of the prior arrangement.

The cross section taken along line II'-II' is almost the same as that shown in FIG.2. The stacked capacitor is not limited to the structure shown in FIG.2. For example, it is possible to form the stacked capacitor so that the storage electrode SE has a single fin. It is also possible to form the stacked capacitor so that the single fin or the lowermost fin from among a plurality of fins is separated from the insulating layer and the opposed electrode is also provided between the single fin or the lowermost fin and the insulating layer.

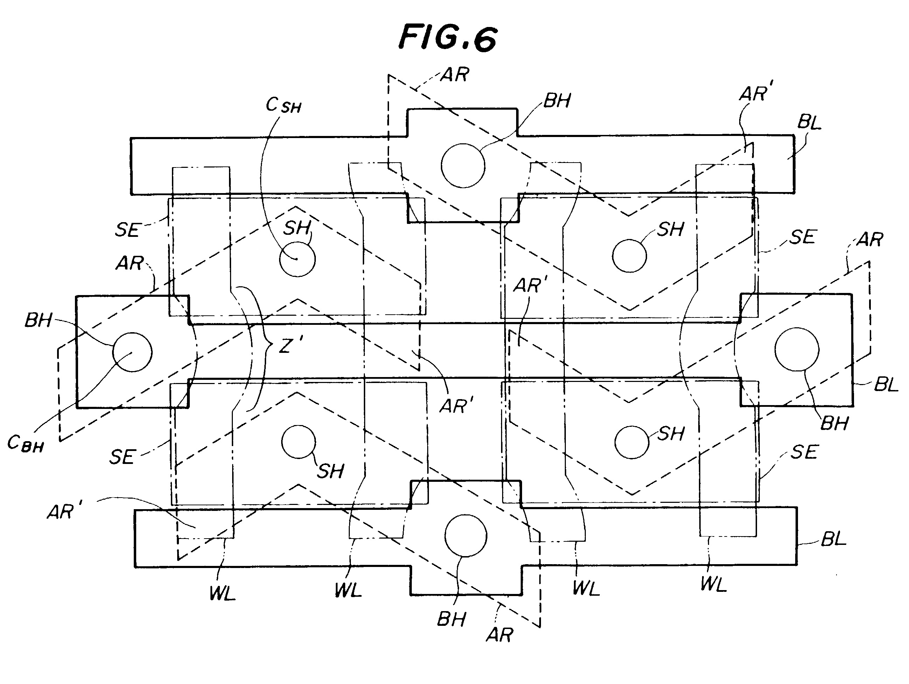

FIG.6 is a diagram showing the layout of four memory cells. In FIG.6, those parts which are the same as those in the previous figures are given the same reference numerals. It will be noted that the bent portion AR' of each active area AR shown in FIG.6 is greater than that shown in FIG.4. That is, the bent portion AR' of each active area AR is located under the corresponding word line WL. It will also be noted that a curved part Z' of each word line WL which crosses the bit line BL is curved without having the areas Z1, Z2 and Z3. Even in the arrangement shown in FIG.6, the imaginary line connecting the center $C_{BH}$ of the bit line contact hole BH and the center $C_{SH}$ of the storage electrode contact hole $C_{SH}$ is perpendicular to the curved part Z' of the word line WL. All of memory cell patterns can be formed by repeatedly arranging the layout shown in FIG.6.

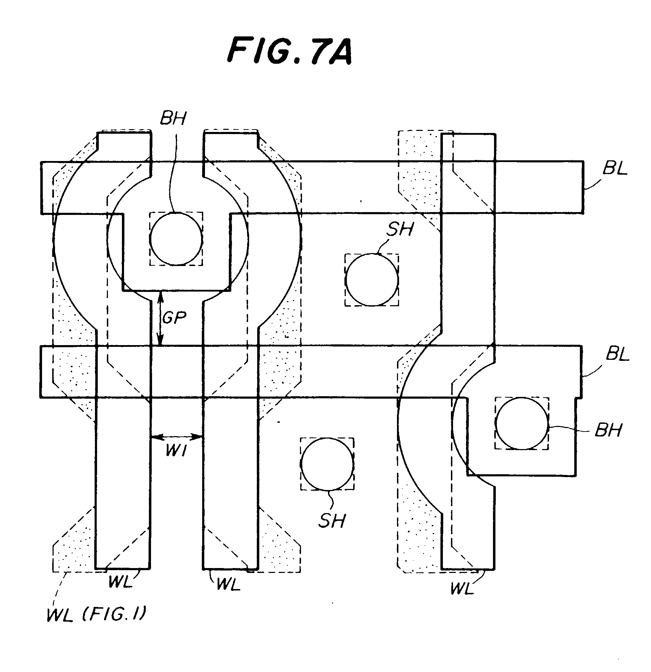

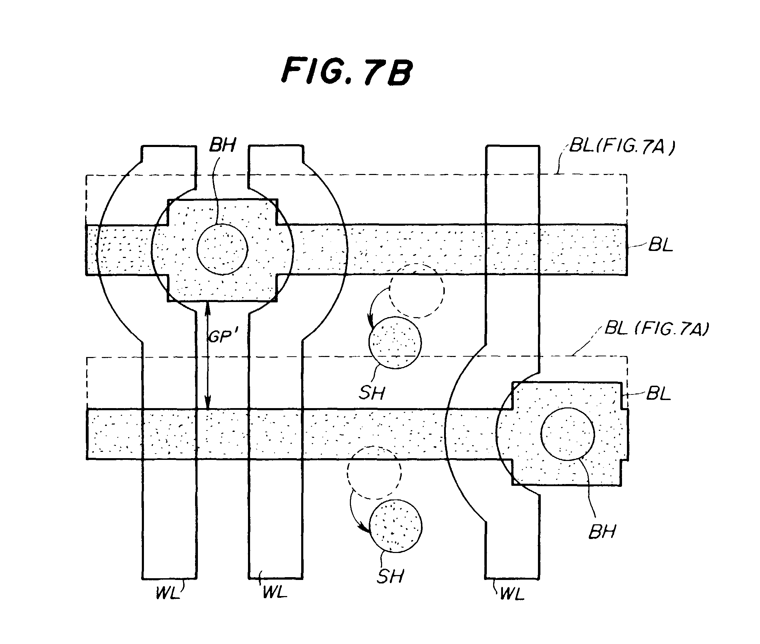

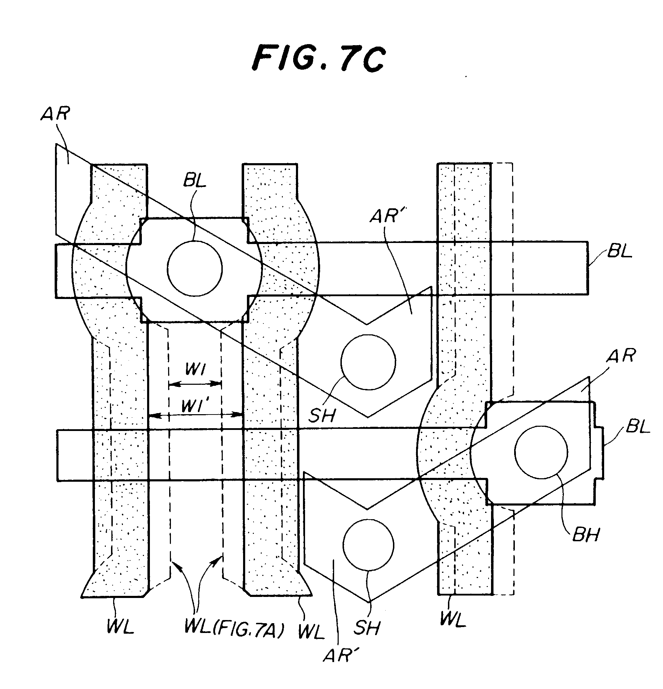

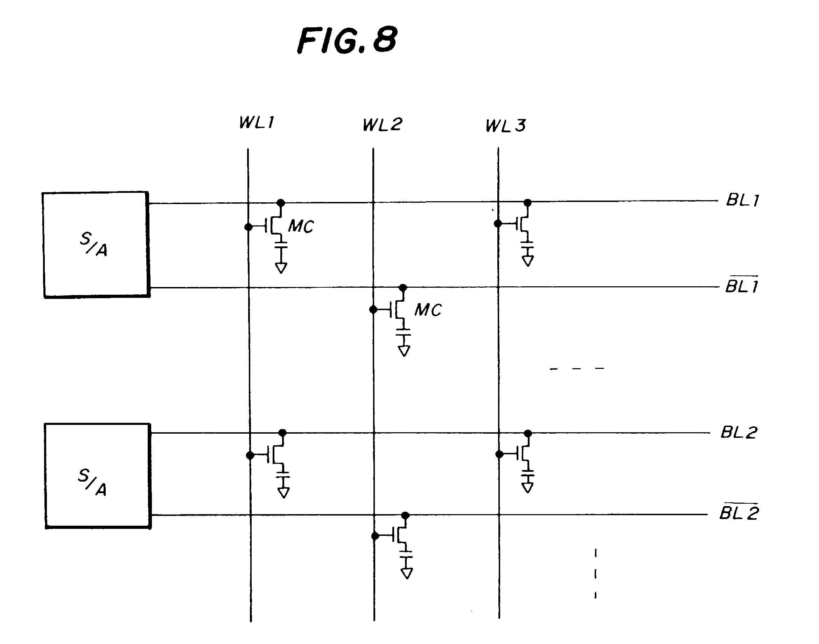

FIGS.7A, 7B and 7C are diagrams illustrating how the present invention was made. In FIGS.7A through 7C, those parts which have the same names as those described previously are given the same reference letters. Referring to FIG.7A, the dotted line illustrates the pattern of the conventional word line WL as shown in FIG.1. A contact hole formed in a fine pattern is approximately of a circle shape due to the intensity distribution of light. Thus, it is possible to consider each contact hole as a circle on the pattern layout drawing. The word lines are required to be separated from the bit line contact holes BH at a predetermined distance. Thus, it is possible to partially shape each word line WL into a circular arc in order to keep away from the bit line contact holes BH at the predetermined distance. As a result, dotted areas between the adjacent word lines WL become available. Thus, as shown in FIG.7B, it becomes possible to obliquely shift the positions of the storage electrode contact holes SH. Due to the positional change in the storage electrode contact holes SH, it becomes possible to shift the positions of the bit lines BL so that the bit line contact holes BH are located at the center thereof, as shown in FIG.7B. Thereby, it is possible to substantially eliminate the bit line extension portions as shown in FIG.1 or FIG.7A so that each bit line BL is substantially straight. In addition, it is possible to increase the distance between the adjacent bit lines BL from GP (FIG.7A) to GP' (FIG.7B). Further, due to this positional change of the storage electrode contact holes SH, it becomes possible to shift the positions of the word lines WL, as illustrated in FIG.7C. As a result, it becomes possible to increase the distance between the opposite edges of the adjacent word lines WL from W1 to W1', as shown in FIG.7C. On the other hand, the distance between the other opposite ends of the adjacent word lines WL is decreased, as shown in FIG.7C. It is possible to arbitrarily determine the distances W1' and W2' on the basis of various requirements. Moreover, FIG.8 is a block diagram of a folded bit line type DRAM. A plurality of pairs of bit lines, such as BL1 and $\overline{BL1}$, extend from corresponding sense amplifiers S/A. A plurality of word lines extend so as to cross the bit lines, as described previously. A memory cell MC is coupled between one of the bit lines and one of the word lines. The pattern arrangements according to the present invention are suitable for the folded bit line type DRAM as shown in FIG.8. However, the arrangements are also applicable to an open bit line type DRAM.

## Claims

1. A dynamic random access memory comprising:

    a semiconductor substrate (1) having an active region (AR) including first and second diffusion regions (D, S) of a transfer transistor,
    an insulating layer (2, 3) formed on said semiconductor substrate and having first and second contact holes (SH, BH),
    a stacked capacitor (SC) having a storage electrode (SE) which is electrically connected to said first diffusion region through said first contact hole formed in said insulating layer and an opposed electrode (CP),
    a word line (WL) dielectrically isolated from said semiconductor substrate, and
    a bit line (BL) electrically isolated from said semiconductor substrate and electrically connected to said second diffusion region through said second contact hole formed in said insulating layer,
    said second contact hole being positioned at a center of said bit line,
    said active region (AR) being obliquely arranged with respect to said bit line (BL) and said word line (WL), and the second diffusion region being disposed so as to cross the bit line,
    characterized in that said word line has a bent portion (Z, Z') located between said first and second contact holes so that said word line is seperated from said second contact hole by a predetermined distance,
    and in that the active region (AR) comprises a bent active portion (AR') which is bent at a centre ($C_{SH}$) of said first contact hole (SH) and which extends toward said bit line (BL).

2. A dynamic random access memory as claimed in claim 1, characterized in that said bent portion (Z, Z') of the word line is arranged so that said bent portion is orthogonal to an imaginary line which connects a center ($C_{SH}$) of said first contact hole (SH) and a center ($C_{BH}$) of said second contact hole (BH).

3. A dynamic random access memory as claimed in claim 1, wherein said active region (AR) is arranged along an imaginary line which connects a center ($C_{SH}$) of said first contact hole (SH) and a center ($C_{BH}$) of said second contact hole (BH).

4. A dynamic random access memory as claimed in any of claims 1 to 3, characterized in that said bent portion (Z') of the word line has an arc-shaped pattern.

5. A dynamic random access memory as claimed in any of claims 1 to 3, characterized in that:

said bent portion (Z) of the word line has a first area (Z1), a second area (Z2) and a third area (Z3) which are integrally formed in this order;
said second area is orthogonal to said bit line; and
one of said first and second areas is orthogonal to an imaginary line which connects a center ($C_{SH}$) of said first contact hole (SH) and a center ($C_{BH}$) of said second contact hole (BH).

6. A dynamic random access memory as claimed in claim 5, characterized in that said first and third areas (Z1, Z3) are arranged in symmetry with each other about said second area.

7. A dynamic random access memory as claimed in any of claims 1 to 6, characterized in that said active region comprises a bent active portion (AR') extending toward said bit line (BL).

8. A dynamic random access memory as claimed in claim 7, characterized in that:

said active region (AR) comprises a straight portion integrally formed with said bent active portion (AR') thereof; and
said bent active portion of the active region is partially in symmetry with said straight portion about said center ($C_{SH}$) of the first contact hole (SH).

9. A dynamic random access memory as claimed in claim 7, characterized in that said bent active portion (AR') of the active region (AR) has an end which is located below said bit line (BL).

10. A dynamic random access memory as claimed in claim 7, characterized in that said bent active portion (AR') of the active region (AR) is obliquely arranged with respect to said bit line (BL).

11. A dynamic random access memory as claimed in any of claims 1 to 10, characterized in that:

an imaginary line which connects a center ($C_{SH}$) of said first contact hole (SH) and a center ($C_{BH}$) of said second contact hole (BH) is inclined at an angle $\theta$ with respect to a direction in which said bit line (BL) extends; and said angle $\theta$ is defined substantially as follows:

$$\theta = \sin^{-1}[(1/2b + e + c)/(a + c + d + 2e)]$$

where

a: half a width of the second contact hole,
e: an alignment margin of each of said first and second contact holes,
d: a width of the word line,
c: half a width of said second contact hole, and
b: a width of said bit line.

12. A dynamic random access memory as claimed in any of claims 1 to 11, characterized in that said first and second contact holes (SH, BH) are substantially of circular shapes.

13. A dynamic random access memory as claimed in any of claims 1 to 12, characterized in that said first diffusion region is a drain region (D) and said second diffusion region is a source region (S).

14. A dynamic random access memory as claimed in any of claims 1 to 13, wherein said bit line is formed at a layer level lower than that of said opposed electrode (CP).

15. A dynamic random access memory according to claim 1, comprising on said

semiconductor substrate (1):

a plurality of said active regions (AR) each including first and second diffusion regions (D, S) of a respective transfer transistor,

said insulating layer (2, 3) having a plurality of first contact holes (SH) and a plurality of second contact holes (BH),

a plurality of said stacked capacitors (SC) each having a storage electrode (SE) which is electrically connected to a corresponding one of said first diffusion regions through a corresponding one of said first contact holes formed in said insulating layer, and an opposed electrode (CP),

a plurality of said word lines (WL) electrically isolated from said semiconductor substrate, and

a plurality of said bit lines (BL) electrically isolated from said semiconductor substrate, each of said bit lines being electrically connected to a corresponding one of said second diffusion regions through a corresponding one of the second contact holes formed in said insulating layer,

each of said second contact holes being positioned at a center (CL) of said bit lines,

each of said said active regions

(AR) being obliquely arranged with respect to said bit lines (BL) and said word lines (WL),

each second diffusion region being disposed to cross a corresponding bit line,

wherein each of said word lines has a plurality of said bent portions (Z, Z') located between corresponding first and second contact holes each bent portion being seperated from a corresponding one of said second contact holes by said predetermined distance, and

each of said active regions (AR) comprises a bent active portion (AR') which is bent at a center of a corresponding one of the first contact holes (SH) and which extends toward a corresponding one of the bit lines (BL).

16. A dynamic random access memory as claimed in claim 15, characterized in that:

each of said first contact holes (SH) is located at an almost equal distance from two adjacent word lines from among said plurality of word lines (WL);

each of said first contact holes is located at an almost equal distance from two adjacent bit lines from among said plurality of bit lines (BL).

17. A dynamic random access memory as claimed in claim 15 claim 16, characterized in that each bent portion (Z, Z') of each of the word lines (WL) is arranged so that each bent portion is orthogonal to an imaginary line which connects a center ($C_{SH}$) of said corresponding one of the first contact holes (SH) and a center ($C_{BH}$) of said corresponding one of the second contact holes (BH).

18. A dynamic random access memory as claimed in claim 15, characterized in that each of said active regions (AR) is arranged along an imaginary line which connects a center ($C_{SH}$) of a corresponding one of said first contact holes (SH) and a center ($C_{BH}$) of a corresponding one of said second contact holes (BH).

19. A dynamic random access memory as claimed in any of claims 15 to 18, characterized in that each bent portion of each of the the word lines (WL) has an arc-shaped pattern (Z').

20. A dynamic random access memory as claimed in any of claims 15 to 18, characterized in that each of said active regions (AR) comprises a bent active portion (AR') extending toward a corresponding one of the bit lines (BL).

21. A dynamic random access memory as claimed in claim 20, characterized in that:

each of said active regions (AR) comprises a straight portion integrally formed with said bent active portion (AR') thereof; and

said bent active portion of each of the active regions is partially in symmetry with said straight portion about said center ($C_{SH}$) of said corresponding one of the first contact holes (SH).

22. A dynamic random access memory as claimed in claim 20, characterized in that said bent active portion (AR') of each of said active regions (AR) has an end which is located below a corresponding one of the bit lines (BL).

23. A dynamic random access memory as claimed in claim 20, characterized in that said bent active portion (AR') of each of said active regions (AR) is obliquely arranged with respect to a corresponding one of the bit lines (BL).

24. A dynamic random access memory as claimed in any of claims 15 to 23, characterized in that:

an imaginary line which connects the center of one of said first contact holes (SH) and a center of a corresponding one of said second contact holes (BH) is inclined at an angle θ with respect to a direction in which said bit lines (BL) extend; and

said angle θ is defined as follows:

$$\theta = \sin^{-1}[(1/2b + e + c)/(a + c + d + 2e)]$$

where

a:  half a width of each of the second contact holes,

e:  an alignment margin of each of said first and second contact holes

d:  a width of each of the word lines, half a width of each of said second contact holes, and

b:  a width of said bit lines.

25. A dynamic random access memory as claimed in any of claims 15 to 24, characterized in that said first and second contact holes (SH, BH) are substantially of circular shapes.

26. A dynamic random access memory as claimed in any of claims 15 to 25, wherein each of said claimed in any of claims 15 to 25, wherein each of said bit lines is formed at a layer level lower than that of said opposed electrode (CP).

27. A dynamic random access memory as claimed in any of claims 15 to 26, wherein said bit lines are of a folded-bit line type.

28. A method of arranging structural elements of a dynamic random access memory according to claim 1 or 15 comprising the steps of:

determining a first position ($C_{SH}$) which is separated from a center (CL) of said bit line at a first predetermined distance;

determining a second position ($C_{BH}$) which is located at the center of said bit line and which is separated from said first position at a second predetermined distance; and

determining a position of said word line (WL) so that said word line is located between said first and second contact holes, wherein:

said first position corresponds to a center ($C_{SH}$) of said first contact hole (SH); and

said second position corresponds to a center ($C_{BH}$) of said second contact hole (BH).

29. A method as claimed in claim 28, characterized in that:

said first predetermined distance is approximately equal to b/2 + c + e where b is a width of said bit line, c is half a width of said first contact hole, and e is an alignment margin of each of said first contact holes;

said second predetermined distance is approximately equal to a + c + d + 2e where a is a half a width of said second contact hole.

30. A method of arranging structural elements of a dynamic random access memory according to claim 1 or 15 comprising the steps of:

determining a first position ($C_{BH}$) which is located at a center (CL) of said bit line,

determining a second position ($C_{SH}$) which is located on an imaginary line extending from said first position at a predetermined angle (θ) with respect to said bit line and which is separated from the center of said bit line at a predetermined distances, and

determining a position of said word line (WL) so that said word line is positioned between said first and second contact holes, wherein:

said first position corresponds to a center ($C_{BH}$) of said second contact hole (BH), and

said second position corresponds to a center ($C_{SH}$) of said first contact hole (SH).

31. A method as claimed in claim 30, characterized in that:

said predetermined angle θ is defined substantially as follows:

$$\theta = \sin^{-1}[(1/2b + e + c)/(a + c + d + 2e)]$$

where

a: half a width of said second contact hole,
e: an alignment margin of each of said first and second contact holes,
d: a width of said word line,
c: half a width of said second contact hole, and
b: a width of said bit line; and

said predetermined distance is approximately equal to b/2 + c + e.

**Patentansprüche**

1. Ein dynamischer Speicher mit wahlfreiem Zugriff, mit:

einem Halbleitersubstrat (1), das eine aktive Zone (AR) hat, die erste und zweite Diffusionszonen (D, S) eines Transfertransistors enthält,
einer Isolierschicht (2, 3), die auf dem genannten Halbleitersubstrat gebildet ist und erste und zweite Kontaktlöcher (SH, BH) hat,
einem Stapelkondensator (SC), der eine Speicherelektrode (SE) hat, die mit der genannten ersten Diffusionszone durch das genannte erste Kontaktloch, das in der genannten Isolierschicht gebildet ist, elektrisch verbunden ist, und eine Gegenelektrode (CP),
einer Wortleitung (WL), die von dem genannten Halbleitersubstrat elektrisch isoliert ist, und
einer Bitleitung (BL), die von dem genannten Halbleitersubstrat elektrisch isoliert ist und mit der genannten zweiten Diffusionszone durch das genannte zweite Kontaktloch, das in der genannten Isolierschicht gebildet ist, elektrisch verbunden ist,
welches zweite Kontaktloch in einer Mitte der genannten Bitleitung positioniert ist,
welche aktive Zone (AR) bezüglich der genannten Bitleitung (BL) und der genannten Wortleitung (WL) schräg angeordnet ist, und
welche zweite Diffusionszone so angeordnet ist, um die Bitleitung zu kreuzen,
dadurch gekennzeichnet, daß die genannte Wortleitung einen gebogenen Abschnitt (Z, Z') hat, der zwischen den genannten ersten und zweiten Kontaktlöchern angeordnet ist, so daß die genannte Wortleitung von dem genannten zweiten Kontaktloch durch einen vorbestimmten Abstand getrennt ist,
und daß die aktive Zone (AR) einen gebogenen aktiven Abschnitt (AR') umfaßt, der in einer Mitte ($C_{SH}$) des genannten ersten Kontaktloches (SH) gebogen ist und sich hin zu der genannten Bitleitung (BL) erstreckt.

2. Ein dynamischer Speicher mit wahlfreiem Zugriff nach Anspruch 1, dadurch gekennzeichnet, daß der genannte gebogene Abschnitt (Z, Z') der Wortleitung so angeordnet ist, daß der genannte gebogene Abschnitt zu einer imaginären Linie, die eine Mitte ($C_{SH}$) des genannten ersten Kontaktloches (SH) und eine mitte ($C_{BH}$) des genannten zweiten Kontaktloches verbindet, orthogonal ist.

3. Ein dynamischer Speicher mit wahlfreiem Zugriff nach Anspruch 1, bei dem die genannte aktive Zone (AR) längs einer imaginären Linie angeordnet ist, die eine Mitte ($C_{SH}$) des genannten ersten Kontaktloches (SH) und eine Mitte ($C_{BH}$) des genannten zweiten Kontaktloches (BH) verbindet.

4. Ein dynamischer Speicher mit wahlfreiem Zugriff nach irgendeinem der Ansprüche 1 bis 3, dadurch gekennzeichnet, daß der genannte gebogene Abschnitt (Z') der Wortleitung ein bogenförmiges Muster hat.

5. Ein dynamischer Speicher mit wahlfreiem Zugriff nach irgendeinem der Ansprüche 1 bis 3, dadurch gekennzeichnet, daß:

der genannte gebogene Abschnitt (Z) der Wortleitung einen ersten Bereich (Z1), einen zweiten Bereich (Z2) und einen dritten Bereich (Z3) hat, die in dieser Reihenfolge integral gebildet sind;
der genannte zweite Bereich zu der genannten Bitleitung orthogonal ist; und
einer der genannten ersten und zweiten Bereiche zu einer imaginären Linie, die eine Mitte ($C_{SH}$) des genannten ersten Kontaktloches (SH) und eine Mitte ($C_{BH}$) des genannten zweiten Kontaktloches (BH) verbindet, orthogonal ist.

6. Ein dynamischer Speicher mit wahlfreiem Zugriff nach Anspruch 5, dadurch gekennzeichnet, daß die genannten ersten und dritten Bereiche (Z1, Z3) um den genannten zweiten Bereich symmetrisch zueinander angeordnet sind.

7. Ein dynamischer Speicher mit wahlfreiem Zugriff nach irgendeinem der Ansprüche 1 bis 6, dadurch gekennzeichnet, daß die genannte aktive Zone einen gebogenen aktiven Abschnitt (AR') umfaßt, der sich hin zu der genannten Bitleitung (BL) erstreckt.

8. Ein dynamischer Speicher mit wahlfreiem Zugriff nach Anspruch 7, dadurch gekennzeichnet, daß:

   die genannte aktive Zone (AR) einen geraden Abschnitt umfaßt, der mit dem genannten gebogenen aktiven Abschnitt (AR') von ihr integral gebildet ist; und
   der genannte gebogene aktive Abschnitt der aktiven Zone mit dem genannten geraden Abschnitt um die genannte Mitte ($C_{SH}$) des ersten Kontaktloches (SH) teilweise symmetrisch ist.

9. Ein dynamischer Speicher mit wahlfreiem Zugriff nach Anspruch 7, dadurch gekennzeichnet, daß der genannte gebogene aktive Abschnitt (AR') der aktiven Zone (AR) ein Ende hat, das unter der genannten Bitleitung (BL) angeordnet ist.

10. Ein dynamischer Speicher mit wahlfreiem Zugriff nach Anspruch 7, dadurch gekennzeichnet, daß der genannte gebogene aktive Abschnitt (AR') der aktiven Zone (AR) bezüglich der genannten Bitleitung (BL) schräg angeordnet ist.

11. Ein dynamischer Speicher mit wahlfreiem Zugriff nach irgendeinem der Ansprüche 1 bis 10, dadurch gekennzeichnet, daß:

   eine imaginäre Linie, die eine Mitte ($C_{SH}$) des genannten ersten Kontaktloches (SH) und eine Mitte ($C_{BH}$) des genannten zweiten Kontaktloches (BH) verbindet, bezüglich einer Richtung, in der sich die genannte Bitleitung (BL) erstreckt, mit einem Winkel θ geneigt ist; und
   der genannte Winkel θ im wesentlichen wie folgt definiert ist:

$$\theta = \sin^{-1}[(1/2b + e + c)/(a + c + d + 2e)]$$

   wobei

   a: die Hälfte einer Breite des zweiten Kontaktloches ist,
   e: ein Ausrichtungsrand von jedem der genannten ersten und zweiten Kontaktlöcher ist,
   d: eine Breite der Wortleitung ist,
   c: die Hälfte einer Breite des genannten zweiten Kontaktloches ist, und
   b: eine Breite der genannten Bitleitung ist.

12. Ein dynamischer Speicher mit wahlfreiem Zugriff nach irgendeinem der Ansprüche 1 bis 11, dadurch gekennzeichnet, daß die genannten ersten und zweiten Kontaktlöcher (SH, BH) im wesentlichen runde Formen haben.

13. Ein dynamischer Speicher mit wahlfreiem Zugriff nach irgendeinem der Ansprüche 1 bis 12, dadurch gekennzeichnet, daß die genannte erste Diffusionszone eine Drainzone (D) ist und die genannte zweite Diffusionszone eine Sourcezone (S) ist.

14. Ein dynamischer Speicher mit wahlfreiem Zugriff nach irgendeinem der Ansprüche 1 bis 13, bei dem die genannte Bitleitung auf einer Schichtebene gebildet ist, die niedriger als jene der genannten Gegenelektrode (CP) ist.

15. Ein dynamischer Speicher mit wahlfreiem Zugriff nach Anspruch 1, der auf dem genannten Halbleitersubstrat (1) umfaßt:

   eine Vielzahl der genannten aktiven Zonen (AR), die jeweils erste und zweite Diffusionszonen (D, S) eines jeweiligen Transfertransistors enthalten,
   welche Isolierschicht (2, 3) eine Vielzahl von ersten Kontaktlöchern (SH) und eine Vielzahl von zweiten Kontaktlöchern (BH) hat,
   eine Vielzahl der genannten Stapelkondensatoren (SC), die jeweils eine Speicherelektrode (SE) haben, die mit einer entsprechenden der genannten ersten Diffusionszonen durch ein entsprechendes der genannten ersten Kontaktlöcher, die in der genannten Isolierschicht gebildet sind, elektrisch verbunden ist, und eine Gegenelektrode (CP),

eine Vielzahl der genannten Wortleitungen (WL), die von dem genannten Halbleitersubstrat elektrisch isoliert sind, und

eine Vielzahl der genannten Bitleitungen (BL), die von dem genannten Halbleitersubstrat elektrisch isoliert sind, von welchen Bitleitungen jede mit einer entsprechenden der genannten zweiten Diffusionszonen durch ein entsprechendes der zweiten Kontaktlöcher, die in der genannten Isolierschicht gebildet sind, elektrisch verbunden ist,

von welchen zweiten Kontaktlöchern jedes in einer Mitte (CL) der genannten Bitleitungen positioniert ist,

von welchen aktiven Zonen (AR) jede bezüglich der genannten Bitleitungen (BL) und der genannten Wortleitungen (WL) schräg angeordnet ist,

wobei jede zweite Diffusionszone angeordnet ist, um eine entsprechende Bitleitung zu kreuzen,

bei dem jede der genannten Wortleitungen eine Vielzahl der genannten gebogenen Abschnitte (Z, Z') hat, die zwischen entsprechenden ersten und zweiten Kontaktlöchern angeordnet sind, wobei jeder gebogene Abschnitt von einem entsprechenden der genannten zweiten Kontaktlöcher durch den genannten vorbestimmten Abstand getrennt ist, und

jede der genannten aktiven Zonen (AR) einen gebogenen aktiven Abschnitt (AR') umfaßt, der in einer Mitte eines entsprechenden der ersten Kontaktlöcher (SH) gebogen ist und sich hin zu einer entsprechenden der Bitleitungen (BL) erstreckt.

16. Ein dynamischer Speicher mit wahlfreiem Zugriff nach Anspruch 15, dadurch gekennzeichnet, daß:

jedes der genannten ersten Kontaktlöcher (SH) in nahezu gleichem Abstand von zwei benachbarten Wortleitungen von der genannten Vielzahl von Wortleitungen (WL) angeordnet ist;

jedes der genannten ersten Kontaktlöcher in nahezu gleichem Abstand von zwei benachbarten Bitleitungen von der genannten Vielzahl von Bitleitungen (BL) angeordnet ist.

17. Ein dynamischer Speicher mit wahlfreiem Zugriff nach Anspruch 15 oder Anspruch 16, dadurch gekennzeichnet, daß jeder gebogene Abschnitt (Z, Z') von jeder der Wortleitungen (WL) so angeordnet ist, daß jeder gebogene Abschnitt zu einer imaginären Linie, die eine Mitte ($C_{SH}$) des genannten entsprechenden der ersten Kontaktlöcher (SH) und eine Mitte ($C_{BH}$) des genannten entsprechenden der zweiten Kontaktlöcher (BH) verbindet, orthogonal ist.

18. Ein dynamischer Speicher mit wahlfreiem Zugriff nach Anspruch 15, dadurch gekennzeichnet, daß jede der genannten aktiven Zonen (AR) längs einer imaginären Linie angeordnet ist, die eine Mitte ($C_{SH}$) eines entsprechenden der genannten ersten Kontaktlöcher (SH) und eine Mitte ($C_{BH}$) eines entsprechenden der genannten zweiten Kontaktlöcher (BH) verbindet.

19. Ein dynamischer Speicher mit wahlfreiem Zugriff nach irgendeinem der Ansprüche 15 bis 18, dadurch gekennzeichnet, daß jeder gebogene Abschnitt von jeder der Wortleitungen (WL) ein bogenförmiges Muster (Z') hat.

20. Ein dynamischer Speicher mit wahlfreiem Zugriff nach irgendeinem der Ansprüche 15 bis 18, dadurch gekennzeichnet, daß jede der genannten aktiven Zonen (AR) einen gebogenen aktiven Abschnitt (AR') umfaßt, der sich hin zu einer entsprechenden der Bitleitungen (BL) erstreckt.

21. Ein dynamischer Speicher mit wahlfreiem Zugriff nach Anspruch 20, dadurch gekennzeichnet, daß:

jede der genannten aktiven Zonen (AR) einen geraden Abschnitt umfaßt, der mit dem genannten gebogenen aktiven Abschnitt (AR') von ihr integral gebildet ist; und

der genannte gebogene aktive Abschnitt von jeder der aktiven Zonen mit dem genannten geraden Abschnitt um die genannte Mitte ($C_{SH}$) des genannten entsprechenden der ersten Kontaktlöcher (SH) teilweise symmetrisch ist.

22. Ein dynamischer Speicher mit wahlfreiem Zugriff nach Anspruch 20, dadurch gekennzeichnet, daß der genannte gebogene aktive Abschnitt (AR') von jeder der genannten aktiven Zonen (AR) ein Ende hat, das unter einer entsprechenden der Bitleitungen (BL) angeordnet ist.

23. Ein dynamischer Speicher mit wahlfreiem Zugriff nach Anspruch 20, dadurch gekennzeichnet, daß der genannte gebogene aktive Abschnitt (AR') von jeder der genannten aktiven Zonen (AR) bezüglich einer entsprechenden der Bitleitungen (BL) schräg angeordnet ist.

24. Ein dynamischer Speicher mit wahlfreiem Zugriff nach irgendeinem der Ansprüche 15 bis 23, dadurch gekennzeichnet, daß:

eine imaginäre Linie, die die Mitte von einem der genannten ersten Kontaktlöcher (SH) und eine Mitte eines entsprechenden der genannten zweiten Kontaktlöcher (BH) verbindet, bezüglich einer Richtung, in der sich die genannten Bitleitungen (BL) erstrecken, mit einem Winkel θ geneigt ist; und
der genannte Winkel θ wie folgt definiert ist:

$$\theta = \sin^{-1}[(1/2b + e + c)/(a + c + d + 2e)]$$

wobei

a: die Hälfte einer Breite von jedem der zweiten Kontaktlöcher ist,
e: ein Ausrichtungsrand von jedem der genannten ersten und zweiten Kontaktlöcher ist,
d: eine Breite von jeder der Wortleitungen ist,
c: die Hälfte einer Breite von jedem der genannten zweiten Kontaktlöcher ist, und
b: eine Breite der genannten Bitleitungen ist.

25. Ein dynamischer Speicher mit wahlfreiem Zugriff nach irgendeinem der Ansprüche 15 bis 24, dadurch gekennzeichnet, daß die genannten ersten und zweiten Kontaktlöcher (SH, BH) im wesentlichen runde Formen haben.

26. Ein dynamischer Speicher mit wahlfreiem Zugriff nach irgendeinem der Ansprüche 15 bis 25, bei dem jede der genannten Bitleitungen auf einer Schichtebene gebildet ist, die niedriger als jene der genannten Gegenelektrode (CP) ist.

27. Ein dynamischer Speicher mit wahlfreiem Zugriff nach irgendeinem der Ansprüche 15 bis 26, bei dem die genannten Bitleitungen ein gefalteter Bitleitungstyp sind.

28. Ein Verfahren zum Anordnen von strukturellen Elementen eines dynamischen Speichers mit wahlfreiem Zugriff nach Anspruch 1 oder 15, mit den Schritten:

Bestimmen einer ersten Position ($C_{SH}$), die von einer Mitte (CL) der genannten Bitleitung durch einen ersten vorbestimmten Abstand getrennt ist;
Bestimmen einer zweiten Positon ($C_{BH}$), die in der Mitte der genannten Bitleitung angeordnet ist und von der genannten ersten Position durch einen zweiten vorbestimmten Abstand getrennt ist; und
Bestimmen einer Position der genannten Wort leitung (WL), so daß die genannte Wortleitung zwischen den genannten ersten und zweiten Kontaktlöchern angeordnet ist, bei dem:
die genannte erste Position einer Mitte ($C_{SH}$) des genannten ersten Kontaktloches (SH) entspricht; und
die genannte zweite Position einer Mitte ($C_{BH}$) des genannten zweiten Kontaktloches (BH) entspricht.

29. Ein Verfahren nach Anspruch 28, dadurch gekennzeichnet, daß:

der genannte erste vorbestimmte Abstand nahezu gleich b/2 + c + e ist, wobei b eine Breite der genannten Bitleitung ist, c die Hälfte einer Breite des genannten ersten Kontaktloches ist, und e ein Ausrichtungsrand von jedem der genannten ersten Kontaktlöcher ist;
der genannte zweite vorbestimmte Abstand nahezu gleich a + c + d + 2e ist, wobei a eine Hälfte einer Breite des genannten zweiten Kontaktloches ist.

30. Ein Verfahren zum Anordnen von strukturellen Elementen eines dynamischen Speichers mit wahlfreiem Zugriff nach Anspruch 1 oder 15, mit den Schritten:

Bestimmen einer ersten Position ($C_{BH}$), die in einer Mitte (CL) der genannten Bitleitung angeordnet ist;
Bestimmen einer zweiten Position ($C_{SH}$), die auf einer imaginären Linie angeordnet ist, die sich von der genannten ersten Position mit einem vorbestimmten Winkel (θ) bezüglich der genannten Bitleitung erstreckt, und die von der Mitte der genannten Bitleitung durch einen vorbestimmten Abstand getrennt ist; und
Bestimmen einer Position der genannten Wortleitung (WL), so daß die genannte Wortleitung zwischen den genannten ersten und zweiten Kontaktlöchern positioniert ist, bei dem:

die genannte erste Position einer Mitte ($C_{BH}$) des genannten zweiten Kontaktloches (BH) entspricht; und die genannte zweite Position einer Mitte ($C_{SH}$) des genannten ersten Kontaktloches (SH) entspricht.

31. Ein Verfahren nach Anspruch 30, dadurch gekennzeichnet, daß:

der genannte vorbestimmte Winkel θ im wesentlichen wie folgt definiert ist:

$$\theta = \sin^{-1}[(1/2b + e + c)/(a + c + d + 2e)]$$

wobei

a: die Hälfte einer Breite des genannten zweiten Kontaktloches ist,
e: ein Ausrichtungsrand von jedem der genannten ersten und zweiten Kontaktlöcher ist,
d: eine Breite der genannten Wortleitungen ist,
c: die Hälfte einer Breite des genannten zweiten Kontaktloches ist, und
b: eine Breite der genannten Bitleitung ist; und

der genannte vorbestimmte Abstand nahezu gleich b/2 + c + e ist.

## Revendications

1. Mémoire vive dynamique comprenant :

un substrat semiconducteur (1) comportant une région active (AR) incluant des première et seconde régions de diffusion (D, S) d'un transistor de transfert ;
une couche d'isolation (2, 3) formée sur ledit substrat semiconducteur et comportant des premier et second trous de contact (SH, BH) ;
un condensateur empilé (SC) comportant une électrode de stockage (SE) qui est connectée électriquement à ladite première région de diffusion par l'intermédiaire dudit premier trou de contact formé dans ladite couche d'isolation et une électrode opposée (CP) ;
une ligne de mot (WL) isolée électriquement dudit substrat semiconducteur ; et
une ligne de bit (BL) isolée électriquement dudit substrat semiconducteur est connectée électriquement à ladite seconde région de diffusion par l'intermédiaire dudit second trou de contact formé dans ladite couche d'isolation ;
ledit second trou de contact étant placé au niveau d'un centre de ladite ligne de bit, ladite région active (AR) étant agencée à l'oblique par rapport à ladite ligne de bit (BL) et à ladite ligne de mot (WL), et la seconde région de diffusion étant placée de manière à croiser la ligne de bit,
caractérisée en ce que ladite ligne de mot comporte une partie inclinée (Z, Z') située entre lesdits premier et second trous de contact de manière à ce que ladite ligne de mot soit séparée dudit second trou de contact par une distance prédéterminée, et en ce que la région active (AR) comprend une partie active inclinée (AR') qui est inclinée au niveau d'un centre ($C_{SH}$) dudit premier trou de contact (SH) et qui s'étend vers ladite ligne de bit (BL).

2. Mémoire vive dynamique selon la revendication 1, caractérisée en ce que ladite partie inclinée (Z, Z') de la ligne de mot est agencée de manière à ce que ladite partie inclinée soit orthogonale à une ligne imaginaire qui relie un centre ($C_{SH}$) dudit premier trou de contact (SH) et un centre ($C_{BH}$) dudit second trou de contact (BH).

3. Mémoire vive dynamique selon la revendication 1, dans laquelle ladite région active (AR) est agencée le long d'une ligne imaginaire qui relie un centre ($C_{SH}$) dudit premier trou de contact (SH) et un centre ($C_{BH}$) dudit second trou de contact (BH).

4. Mémoire vive dynamique selon l'une quelconque des revendications 1 à 3, caractérisée en ce que ladite partie inclinée (Z') de la ligne de mot présente un motif en arc de cercle.

5. Mémoire vive dynamique selon l'une quelconque des revendications 1 à 3, caractérisée en ce que :

ladite partie inclinée (Z) de la ligne de mot comporte une première zone (Z1), une seconde zone (Z2) et une troisième zone (Z3) qui sont formées d'un seul tenant dans cet ordre ;

ladite seconde zone est orthogonale à ladite ligne de bit ; et

l'une desdites première et seconde zones est orthogonale à une ligne imaginaire qui relie un centre ($C_{SH}$) dudit premier trou de contact (SH) et un centre ($C_{BH}$) dudit second trou de contact (BH).

6. Mémoire vive dynamique selon la revendication 5, caractérisée en ce que lesdites première et troisième zones (Z1, Z3) sont agencées de façon symétrique l'une par rapport à l'autre par rapport à ladite seconde zone.

7. Mémoire vive dynamique selon l'une quelconque des revendications 1 à 6, caractérisée en ce que ladite région active comprend une partie active inclinée (AR') s'étendant vers ladite ligne de bit (BL).

8. Mémoire vive dynamique selon la revendication 7, caractérisée en ce que :

ladite région active (AR) comprend une partie droite formée d'un seul tenant avec sa partie active inclinée (AR') ; et

ladite partie active inclinée de la région active est partiellement symétrique à ladite partie droite par rapport audit centre ($C_{SH}$) du premier trou de contact (SH).

9. Mémoire vive dynamique selon la revendication 7, caractérisée en ce que ladite partie active inclinée (AR') de la région active (AR) présente une extrémité qui est située au-dessous de ladite ligne de bit (BL).

10. Mémoire vive dynamique selon la revendication 7, caractérisée en ce que ladite partie active inclinée (AR') de la région active (AR) est agencée à l'oblique par rapport à ladite ligne de bit (BL).

11. Mémoire vive dynamique selon l'une quelconque des revendications 1 à 10, caractérisée en ce que :

une ligne imaginaire qui relie un centre (CSH) dudit premier trou de contact (SH) et un centre (CBH) dudit second trou de contact (BH) est inclinée selon un angle θ par rapport à une direction selon laquelle ladite ligne de bit (BL) s'étend ; et

ledit angle θ est sensiblement défini de la manière suivante :

$$\theta = \sin^{-1}\left[(1/2b + e + c) / (a + c + d + 2e)\right]$$

où

a : une demi-largeur du second trou de contact,
e : une marge d'alignement de chacun desdits premier et second trous de contact,
d : une largeur de la ligne de mot,
c : une demi-largeur dudit second trou de contact, et
b : une largeur de ladite ligne de bit.

12. Mémoire vive dynamique selon l'une quelconque des revendications 1 à 11, caractérisée en ce que lesdits premier et second trous de contact (SH, BH) sont sensiblement de forme circulaire.

13. Mémoire vive dynamique selon l'une quelconque des revendications 1 à 12, caractérisée en ce que ladite première région de diffusion est une région de drain (D) et en ce que ladite seconde région de diffusion est une région de source (S).

14. Mémoire vive dynamique selon l'une quelconque des revendications 1 à 13, dans laquelle ladite ligne de bit est formée à un niveau de couche inférieur à celui de ladite électrode opposée (CP).

15. Mémoire vive dynamique selon la revendication 1, comprenant :

sur ledit substrat semiconducteur (1) : une pluralité desdites régions actives (AR), chacune d'entre elles incluant des première et seconde régions de diffusion (D, S) d'un transistor de transfert respectif ;

ladite couche d'isolation (2, 3) comportant une pluralité de premiers trous de contact (SH) et une pluralité de seconds trous de contact (BH) ;

une pluralité desdits condensateurs empilés (SC), chacun d'entre eux comportant une électrode de stockage (SE) qui est connectée électriquement à l'une correspondante desdites premières régions de diffusion par l'intermédiaire de l'un correspondant desdits premiers trous de contact formés dans ladite couche d'isolation,

et une électrode opposée (CP),
une pluralité desdites lignes de mot (WL) isolées électriquement dudit substrat semiconducteur ; et
une pluralité desdites lignes de bit (BL) isolées électriquement dudit substrat semiconducteur, chacune desdites lignes de bit étant connectée électriquement à l'une correspondante desdites secondes régions de diffusion par l'intermédiaire de l'un correspondant des seconds trous de contact formés dans ladite couche d'isolation ; chacun desdits seconds trous de contact étant placé au niveau d'un centre (CL) desdites lignes de bit, chacune desdites régions actives (AR) étant agencée à l'oblique par rapport auxdites lignes de bit (BL) et auxdites lignes de mot (WL), chaque seconde région de diffusion étant placée de manière à croiser une ligne de bit correspondante ;

dans laquelle chacune desdites lignes de mot comporte une pluralité desdites parties inclinées (Z, Z') situées entre des premier et second trous de contact correspondants, chaque partie inclinée étant séparée de l'un correspondant desdits seconds trous de contact par ladite distance prédéterminée, et chacune desdites régions actives (AR) comprend une partie active inclinée (AR') qui est inclinée au niveau d'un centre de l'un correspondant des premiers trous de contact (SH) et qui s'étend vers l'une correspondante des lignes de bit (BL).

16. Mémoire vive dynamique selon la revendication 15, caractérisée en ce que :

chacun desdits premiers trous de contact (SH) est situé presque à égale distance de deux lignes de mot adjacentes prises parmi ladite pluralité de ligne de mot (WL) ; et
chacun desdits premiers trous de contact est situé presque à égale distance de deux lignes de bit adjacentes prises parmi ladite pluralité de lignes de bit (BL).

17. Mémoire vive dynamique selon la revendication 5 ou 6, caractérisée en ce que ladite partie inclinée (Z, Z') de chacune des lignes de mot (WL) est agencée de manière à ce que chaque partie inclinée soit orthogonale à une ligne imaginaire qui relie un centre ($C_{SH}$) de l'un correspondant des premiers trous de contact (SH) et un centre ($C_{BH}$) dudit correspondant des seconds trous de contact (BH).

18. Mémoire vive dynamique selon la revendication 5, caractérisée en ce que chacune desdites régions actives (AR) est agencée selon une ligne imaginaire qui relie un centre ($C_{SH}$) de l'un correspondant desdits premiers trous de contact (SH) et un centre ($C_{BH}$) de l'un correspondant desdits seconds trous de contact (BH).

19. Mémoire vive dynamique selon l'une quelconque des revendications 5 à 18, caractérisée en ce que chaque partie inclinée de chacune des lignes de mot (WL) présente un motif en arc de cercle (Z').

20. Mémoire vive dynamique selon l'une quelconque des revendications 5 à 18, caractérisée en ce que chacune desdites régions actives (AR) comprend une partie active inclinée (AR') s'étendant vers l'une correspondante des lignes de bit (BL).

21. Mémoire vive dynamique selon la revendication 20, caractérisée en ce que :

chacune desdites régions actives (AR) comprend une partie droite formée d'un seul tenant avec sa dite partie active inclinée (AR') ; et
ladite partie active inclinée de chacune des régions actives est partiellement symétrique à ladite partie droite par rapport audit centre ($C_{SH}$) dudit correspondant des premiers trous de contact (SH).

22. Mémoire vive dynamique selon la revendication 20, caractérisée en ce que ladite partie active inclinée (AR') de chacune desdites régions actives (AR) comporte une extrémité qui est située au-dessous de l'une correspondante des lignes de bit (BL).

23. Mémoire vive dynamique selon la revendication 20, caractérisée en ce que ladite partie active inclinée (AR') de chacune desdites régions actives (AR) est agencée à l'oblique par rapport à l'une correspondante des lignes de bit (BL).

24. Mémoire vive dynamique selon l'une quelconque des revendications 15 à 23, caractérisée en ce que :

une ligne imaginaire qui relie le centre de l'un desdits premiers trous de contact (SH) et un centre de l'un correspondant desdits seconds trous de contact (BH) est inclinée selon un angle θ par rapport à une direction selon laquelle lesdites lignes de bit (BL) s'étendent ; et

ledit angle θ est défini de la manière suivante :

$$\theta = \sin^{-1}\left[(1/2b + e + c) / (a + c + d + 2e)\right]$$

où

a : une demi-largeur de chacun des seconds trous de contact,

e : une marge d'alignement de chacun desdits premiers et seconds trous de contact

d : une largeur de chacune des lignes de mot, une demi-largeur de chacun desdits seconds trous de contact, et

b : une largeur desdites lignes de bit.

**25.** Mémoire vive dynamique selon l'une quelconque des revendications 15 à 24, caractérisée en ce que lesdits premiers et seconds trous de contact (SH, BH) sont sensiblement de forme circulaire.

**26.** Mémoire vive dynamique selon l'une quelconque des revendications 15 à 25, dans laquelle chacune desdites lignes de bit est formée à un niveau de couche inférieur à celui de ladite électrode opposée (CP).

**27.** Mémoire vive dynamique selon l'une quelconque des revendications 15 à 26, dans laquelle lesdites lignes de bit sont du type ligne de bit repliée.

**28.** Procédé d'agencement d'éléments structurels d'une mémoire vive dynamique selon la revendication 1 ou 15, comprenant les étapes de :

détermination d'une première position ($C_{SH}$) qui est séparée d'un centre (CL) de ladite ligne de bit d'une première distance prédéterminée ;

détermination d'une seconde position ($C_{BH}$) qui est située au niveau du centre de ladite ligne de bit et qui est séparée de ladite première position d'une seconde distance prédéterminée ; et

détermination d'une position de ladite ligne de mot (WL) de manière à ce que ladite ligne de mot soit située entre lesdits premiers et seconds trous de contact, dans laquelle :

ladite première position correspond à un centre ($C_{SH}$) dudit premier trou de contact (SH) ; et

ladite seconde position correspond à un centre ($C_{BH}$) dudit second trou de contact (BH).

**29.** Procédé selon la revendication 28, caractérisé en ce que :

ladite première distance prédéterminée est approximativement égale à b/2 + c + e où b est une largeur de ladite ligne de bit, c est une demi-largeur dudit premier trou de contact et e est une marge d'alignement de chacun desdits premiers trous de contact ;

ladite seconde distance prédéterminée est approximativement égale à a + c + d + 2e où a est une demi-largeur dudit second trou de contact.

**30.** Procédé d'agencement d'éléments structurels d'une mémoire vive dynamique selon la revendication 1 ou 15, comprenant les étapes de :

détermination d'une première position ($C_{BH}$) qui est située au niveau d'un centre (CL) de ladite ligne de bit ;

détermination d'une seconde position ($C_{SH}$) qui est située sur une ligne imaginaire s'étendant depuis ladite première position selon un angle prédéterminé (θ) par rapport à ladite ligne de bit et qui est séparée du centre de ladite ligne de bit d'une distance prédéterminée ; et

détermination d'une position de ladite ligne de mot (WL) de manière à ce que ladite ligne de mot soit située entre lesdits premiers et seconds trous de contact, dans laquelle :

ladite première position correspond à un centre ($C_{BH}$) dudit second trou de contact (BH) ; et

ladite seconde position correspond à un centre ($C_{SH}$) dudit premier trou de contact (SH).

**31.** Procédé selon la revendication 30, caractérisé en ce que :

ledit angle θ prédéterminé est sensiblement défini de la manière suivante :

$$\theta = \sin^{-1}\left[(1/2b + e + c) / (a + c + d + 2e)\right]$$

où

a : une demi-largeur dudit second trou de contact,

e : une marge d'alignement de chacun desdits premiers et seconds trous de contact,

d : une largeur de ladite ligne de mot,

c : une demi-largeur dudit second trou de contact, et

b : une largeur de ladite ligne de bit ; et

ladite distance prédéterminée est approximativement égale à b/2 + c + e.

FIG. 1 PRIOR ART

# FIG.2 PRIOR ART

# FIG.3

$C_{SH}$

$TA$

$C_{BH}$

$CL$

$\theta$

$BL$

$a + c + d + 2e$

$\dfrac{b}{2} + c + e$

$TA$

$C_{SH}$

# FIG.5A

$Si_3N_4$

# FIG.5B

$OY$

$OX$

$Si_3N_4$

**FIG. 4**

## FIG.6

# FIG.7A

# FIG. 7B

FIG.7C

# FIG.8